# EUROPÄISCHE PATENTSCHRIFT

(11) **EP 0 880 655 B1**
(45) Veröffentlichungstag und Bekanntmachung des Hinweises auf die Patenterteilung: **26.04.2000**
(21) Anmeldenummer: 97908132.0
(22) Anmeldetag: 10.02.1997
(51) Int. Cl.: F16H 61/00

(54) **STEUERGERÄT FÜR EIN AUTOMATISCHES GETRIEBE**
AUTOMATIC TRANSMISSION CONTROL APPARATUS
APPAREIL DE COMMANDE POUR TRANSMISSION AUTOMATIQUE

(30) Priorität: 21.02.1996 DE 19606481
(43) Veröffentlichungstag der Anmeldung: 02.12.1998
(73) Patentinhaber: SIEMENS AKTIENGESELLSCHAFT, 80333 München (DE)
(72) Erfinder: FRITZSCHE, Christian, D-93047 Regensburg (DE)
(86) Internationale Anmeldenummer: DE9700252
(87) Internationale Veröffentlichungsnummer: WO9731199

(56) Entgegenhaltungen:
- WO-A-91/12428
- DE-C- 4 415 133
- FR-A- 2 696 226

## Beschreibung

Die Erfindung betrifft ein Steuergerät für ein automatisches Getriebe in einem Kraftfahrzeug. Es weist ein Gehäuse auf, in dem ein Träger mit einer elektronischen Schaltung enthalten ist, die die Steuerfunktionen für das Getriebe durchführt, und es ist mit mehreren Drehzahlsensoren versehen, durch die die Drehbewegungen von rotierenden Teilen erfaßt werden, die in dem Getriebegehäuse angeordnet sind. Solche rotierenden Teile sind Getriebewellen, z.B. die Getriebeeingangs- und die Getriebeausgangswelle sowie auf derartigen Wellen angeordnete Zahnräder.

Bei einem bekannten Steuergerät für ein automatisches Getriebe wird in das Unterteil des Steuergerätegehäuses eine elastische Masse eingebracht, in die unter anderem ein Drehzahlsensor eingebettet wird (DE 44 15 133 C1). Das Steuergerätegehäuse wird in eine Öffnung des Getriebegehäuses eingesteckt und an diesem befestigt.

Der Erfindung liegt die Aufgabe zugrunde, ein Steuergerät zu schaffen, mit dem die Drehzahlen von rotierenden Teilen in einem automatischen Stufengetriebe oder in einem stufenlosen Getriebe kostengünstig erfaßt werden können. Drehzahlsensoren sollen mit möglichst geringem Montageaufwand in der Nähe der rotierenden Teile angebracht und gegen die dort herrschenden Umweltbedingungen gut geschützt werden können. Ist das Steuergerät im Inneren eines Getriebegehäuses untergebracht, so muß es gegen spritzendes Getriebeöl und gegen die im Getriebeinneren herrschende erhöhte Temperatur geschützt werden.

Diese Aufgabe wird durch ein Steuergerät mit den Merkmalen von Anspruch 1 gelöst.

Das Gehäuse des Steuergeräts weist einen Dichtrahmen auf, der zusammen mit einer Grundplatte und einem Deckel einen mit geringem Aufwand hermetisch abgedichteten Innenraum bildet. Dadurch, daß die Drehzahlsensoren in dem Kunststoffrahmen integriert sind, indem sie beispielsweise zusammen mit ihm als Spritzgußteil aus Kunststoff hergestellt werden, wird die Anzahl der erforderlichen Einzelteile verringert. Die Drehzahlsensoren benötigen kein eigenes Gehäuse und müssen nicht in einem getrennten Arbeitsgang in das Gehäuse eingebaut werden.

Vorteilhafte Weiterbildungen der Erfindung sind in den Unteransprüchen niedergelegt. Ein Ausführungsbeispiel der Erfindung wird im folgenden anhand der Zeichnung erläutert. Es zeigen:
- Figur 1: ein erfindungsgemäßes Steuergerät ohne Deckel aber mit Anschlußstecker,
- Figur 2: einen Dichtrahmen des Steuergeräts nach Figur 1 in der Draufsicht,
- Figur 3: den Dichtrahmen nach Figur 2 in einer Schnittansicht und
- Figur 4: einen schematischen Ausschnitt aus dem Gehäuse des Steuergeräts nach Figur 1 mit aufgesetztem Deckel.

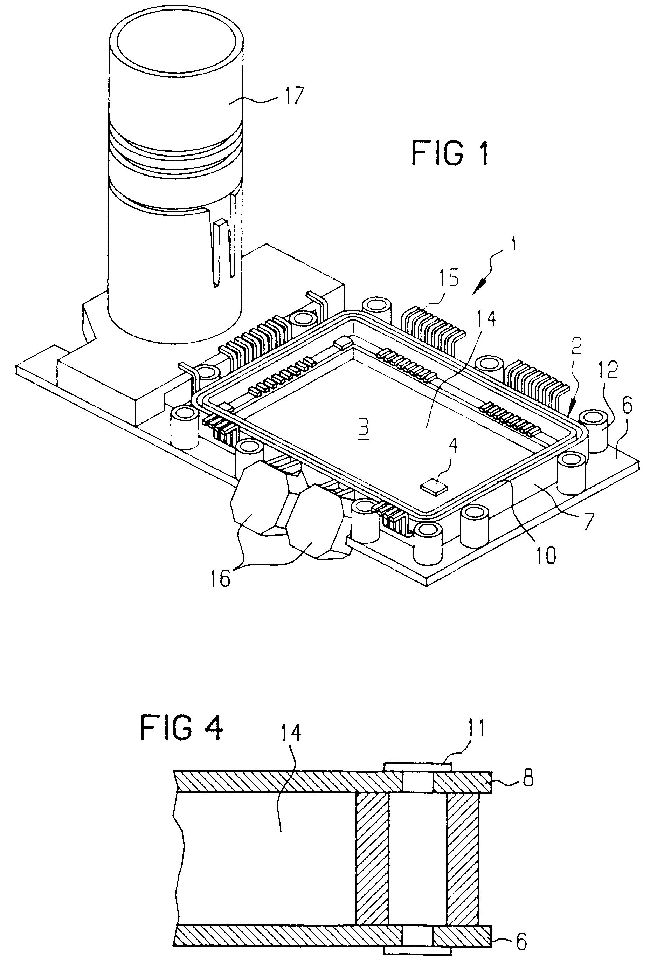

Ein Steuergerät 1 (Figur 1) weist ein hermetisch dichtes Gehäuse 2 und einen Träger 3 für eine elektronische Schaltung auf. Der Träger 3 ist z.B. als Leiterplatte ausgebildet, auf der die elektronischen Schaltungsbestandteile einschließlich der Leiterbahnen oder sonstigen elektrischen Verbindungen angeordnet sind. Die elektronische Schaltung auf dem Träger 3 enthält unter anderem einen Mikroprozessor, sie wertet die Signale verschiedener Sensoren - insbesondere von Druck- und Drehzahlsensoren - aus und steuert verschiedene Aktuatoren, die unter anderem die Getriebeübersetzung festlegen. Da sie allgemein bekannt und von der Erfindung nicht berührt wird, wird sie hier nicht im einzelnen dargestellt. Von dieser elektronischen Schaltung ist hier zu Verdeutlichung lediglich ein Bauteil oder Schaltungselement 4 dargestellt,

Das Gehäuse 2 besteht aus einer Grundplatte 6, einem Dichtrahmen 7 und einem Deckel 8 (in Figur 1 abgenommen, vgl. Figur 4). An seinem oberen und seinem unteren Rand ist der Dichtrahmen 7 je mit einer Nut 10 versehen, in die eine Dichtung geeigneter Form eingelegt wird. Die drei Bestandteile 6, 7 und 8 des Dichtrahmens 2 werden durch Nieten 11 (vgl. Figur 4), die durch zylinderförmige Nietaugen 12 des Dichtrahmens 7 hindurchgesteckt sind, miteinander verbunden, und zwar so, daß sich ein hermetisch abgedichteter Innenraum 14 bildet, der den Träger 3 samt der darauf angeordneten elektronischer Schaltung aufnimmt.

Streifenförmige Anschlüsse oder Kontaktbahnen 15, die die elektronische Schaltung auf dem Träger 3 mit den jeweils zugeordneten Elementen des (hier nicht dargestellten) Getriebes verbinden, sind in den Dichtrahmen vergossen oder eingespritzt. Sie sind somit vollkommen dicht aus dem Gehäuse 2 herausgeführt. Die Dichtbahnen 15 führen zu den verschiedenen Sensoren und Aktuatoren in dem Getriebe, sie verbinden die elektronische Schaltung außerdem mit einem Stecker 17, über den das Steuergerät mit einem nicht dargestellten Kabelbaum des Kraftfahrzeugs verbunden wird.

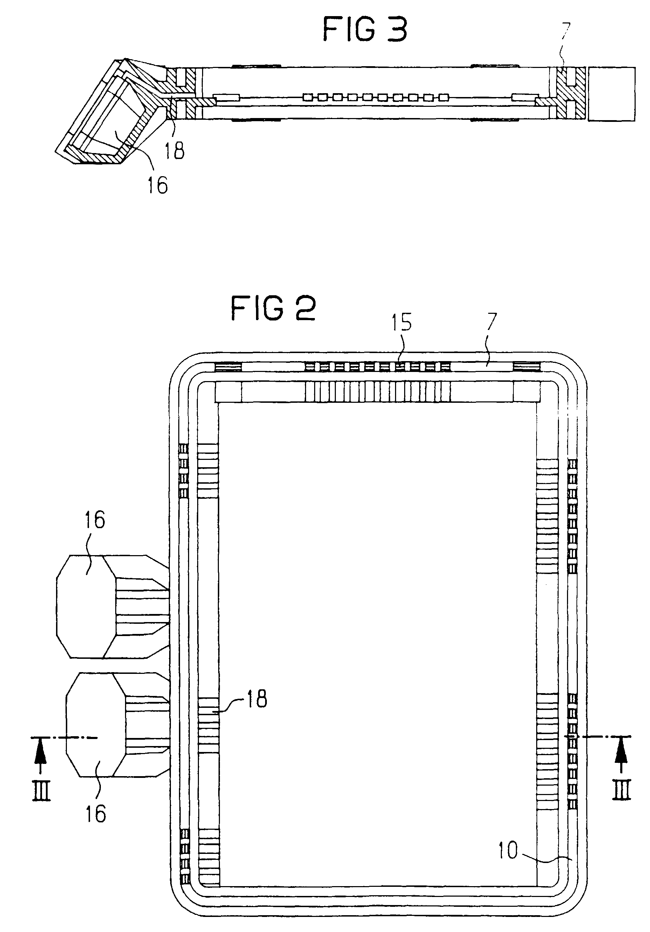

Drehzahlsensoren 16, mit denen Drehbewegungen von rotierenden Teilen des Getriebes, z.B. den Treibrädern eines stufenlosen Getriebes (üblicherweise auch als CVT bezeichnet) erfaßt werden, sind in den Dichtrahmen 7 eingespritzt (Figur 3). Die elektrische Verbindung zwischen den Drehzahlsensoren 16 und der elektronischen Schaltung auf dem Träger 3 erfolgt durch ebenfalls in den Dichtrahmen 7 eingespritzte streifenförmige Anschlüsse oder Kontaktbahnen 18. Die Kontaktbahnen 15 und 18 werden in Form eines Stanzgitters hergestellt, das aus einem Metallblech ausgestanzt wird und als gitterförmiges Gebilde gut handhabbar ist. Nach dem Einspritzen in den Dichtrahmen und ggf. weiteren Bearbeitungsschritten werden die Querstege entfernt und so die Leiterbahnen vereinzelt.

Das Integrieren der Drehzahlsensoren in den Dichtrahmen, der z.B. als spritzgegossenes Kunststoffteil hergestellt wird, weist folgende Vorteile auf: Die Herstellungskosten werden verringert, da kein separates, dichtes Gehäuse für die Sensormodule benötigt werden. Außerdem werden die Montagekosten verringert, da eine separate Befestigung der Sensoren und die Kabel zu den Sensoren entfallen (letztere werden durch das kostengünstige Stanzgitter) ersetzt. Die als Stanzgitter hergestellten Anschlußbahnen 15 und 18 können im Inneren des Gehäuses 2 mit den Schaltungsbestandteilen des Trägers 3 verbunden werden. Die Notwendigkeit einer dichten Kontaktdurchführung für diese Sensoren entfällt, da sie in dem dichten Innenraum ankontaktiert werden. Die Drehzahlsensoren 16 sind außerdem gegen das im Inneren des Getriebes enthaltene, während des Betriebes erhitzte ATF-Öl wirksam abgedichtet.

Das Steuergerät kann mit seiner Grundplatte an geeigneter Stelle innerhalb des Getriebegehäuses befestigt, zum Beispiel angeschraubt, werden. Eine geeignete Stelle ist z.B. ein hydraulische Steuerventile enthaltendes Hydraulikgehäuse in dem Getriebe.

### Bezugszeichen:

- 1: Steuergerät (Getriebesteuerung)
- 2: Gehäuse, hermetisch dicht
- 3: Träger (Leiterplatte für elektronische Schaltung)
- 4: Schaltungselement, Bauteil
- 6: Grundplatte
- 7: Dichtrahmen
- 8: Deckel
- 10: Nut (für Dichtung)
- 11: Niete
- 12: zylinderförmige Nietaugen
- 14: Innenraum, hermetisch abgedichtet
- 15: Anschluß oder Kontaktbahn, streifenförmig
- 16: Drehzahlsensoren
- 17: Stecker
- 18: Anschluß oder Kontaktbahn, streifenförmig

## Patentansprüche

1. Steuergerät (1) für ein automatisches Getriebe in einem Kraftfahrzeug, mit
- einem, eine Grundplatte (6) und einen Deckel (8) aufweisenden Gehäuse (2), in dem ein Träger (3) mit einer elektronischen Schaltung (4) enthalten ist,
- einem Dichtrahmen (7), der zusammen mit der Grundplatte (6) und dem Deckel (8) einen hermetisch abgedichteten Innenraum (14) bildet und
- mit mehreren, vollständig in den Dichtrahmen (7) integrierten Drehzahlsensoren (16), durch die Drehbewegungen von in dem Getriebegehäuse angeordneten rotierenden Teilen erfaßt werden.

2. Steuergerät nach Anspruch 1, dadurch gekennzeichnet, daß der Dichtrahmen (7) als Spritzgußteil aus Kunststoff besteht.

3. Steuergerät nach Anspruch 1, dadurch gekennzeichnet, daß die Drehzahlsensoren (16) durch in den Dichtrahmen (7) eingelegte und umspritzte Kontaktbahnen (18) mit der elektronischen Schaltung verbunden sind.

4. Steuergerät nach Anspruch 3, dadurch gekennzeichnet, daß die Kontaktbahnen (16, 18) als aus Metallblech ausgestanztes Gitter hergestellt und nach dem Einbau vereinzelt werden.

## Claims

1. Control unit (1) for an automatic gearbox in a motor vehicle, with
- a housing (2) including a baseplate (6) and a cover (8), and containing a carrier (3) with an electronic circuit (4),
- a sealing frame (7) which, together with the baseplate (6) and a cover (8), forms a hermetically sealed interior (14), and
- a number of rotational speed sensors (16), totally integrated into the sealing frame (7), which serve to register rotational movements of rotating parts located in the gearbox housing.

2. Control unit in accordance with Claim 1, characterised in that the sealing frame (7) consists of an injection-moulded plastic part.

3. Control unit in accordance with Claim 1, characterised in that the rotational speed sensors (16) are connected to the electronic circuit by means of contactor strips (18) inserted and spray-moulded into the sealing frame (7).

4. Control unit in accordance with Claim 3, characterised in that the contactor strips (16, 18) are manufactured as a grid stamped out of sheet metal and are separated after mounting.

## Revendications

1. Appareil de commande (1) pour une boîte de vitesses automatique dans un véhicule automobile, comportant
- un carter présentant une plaque de base (6) et un couvercle (8) et dans lequel est placé un support (3) comportant un circuit électronique (4),
- un cadre d'étanchéité (7), qui constitue, avec la plaque de fond (6) et le couvercle (8), un espace intérieur 14 rendu hermétiquement étanche, et
- comportant plusieurs capteurs de vitesse de rotation (16) complètement intégrés dans le cadre d'étanchéité (7), par lesquels sont détectés des mouvements de rotation de pièces tournantes disposées dans le carter de boîte de vitesses.

2. Appareil de commande suivant la revendication 1, caractérisé en ce que le cadre d'étanchéité (7) est constitué de matière plastique, sous la forme d'une pièce moulée par injection.

3. Appareil de commande suivant la revendication 2, caractérisé en ce que les capteurs de vitesse de rotation (16) sont reliés au circuit électronique par des pistes de contact (18) intégrées dans le cadre d'étanchéité (7) et noyées dans le produit injecté.

4. Appareil de commande suivant la revendication 3, caractérisé en ce que les pistes de contact (15, 18) sont fabriquées sous la forme d'une grille, obtenue par poinçonnage d'une tôle métallique, et sont séparées les unes des autres après montage.
